# EUROPEAN PATENT APPLICATION

(11) **EP 1 742 264 A2**
(43) Date of publication of application: **10.01.2007**
(21) Application number: 06012949.1
(22) Date of filing: 23.06.2006
(51) Int. Cl.: H01L 23/473

(54) **A monolithic fluid cooled power module and a method of forming the power module**

(30) Priority: 05.07.2005 DK 200500987
(71) Applicant: Danfoss Silicon Power GmbH, 24837 Schleswig (DE)
(72) Inventor: Eisele, Ronald, 24229 Surendorf (DE); Olesen, Klaus Kristen, 6400 Sonderborg (DK)
(74) Representative: Inspicos A/S

(57) **Abstract**

A monolithic fluid cooled power module comprising a cooling plate with at least one substrate mounted thereon and a cooling module adapted to distribute a flow of fluid over a surface to be cooled. The cooling plate and the cooling module have been assembled in an at least substantially fluid tight manner, and in an at least substantially irreversible manner, and in such a way that the cooling module can distribute a flow of fluid over a surface of the cooling plate. Thereby the cooling plate and the cooling module form a monolithic unit.

Since the cooling plate and the cooling module have been assembled in an at least substantially fluid tight and irreversible manner, the risk of leaking cooling fluid is considerably reduced as compared to prior art systems, even if the cooling fluid is under pressure.

The cooling plate and the cooling module are preferably assembled using friction stir welding.

## Description

### FIELD OF THE INVENTION

The present invention relates to a cooling module for providing cooling to a surface which needs cooling. More particularly the present invention relates to a cooling unit for cooling electronic components, power modules comprising power semiconductors, etc.

### BACKGROUND OF THE INVENTION

It is known in the art to mount a substrate on a cooling plate in order to provide cooling for electronic components mounted on the substrate. Such a module is known as a 'power module'. It is also known to attach the cooling plate to a cooling module, e.g. in order to transport heat away from the cooling plate, e.g. by means of fluid cooling, such as liquid cooling. In order to provide a good thermal contact between the cooling plate and the cooling fluid, it is desirable that no other parts are present between these, i.e. the cooling fluid of the cooling module should preferably be in direct contact with the cooling plate. However, this requirement makes it difficult to ensure that the cooling fluid is maintained inside the cooling module, i.e. to prevent leaking of cooling fluid, in particular in case the cooling fluid is under pressure.

### SUMMARY OF THE INVENTION

It is, thus, an object of the present invention to provide a power module which is capable of providing fluid cooling to a cooling plate in an efficient manner, while preventing leaking of cooling fluid, even if the cooling fluid is under pressure.

It is a further object of the present invention to provide a method of forming a fluid cooled power module for cooling a cooling plate in an efficient manner, in such a way that leaking of cooling fluid is prevented, even of the cooling fluid is under pressure.

According to a first aspect of the present invention the above and other objects are fulfilled by providing a monolithic fluid cooled power module comprising a cooling plate with at least one substrate mounted thereon and a cooling module adapted to distribute a flow of fluid over a surface to be cooled, wherein the cooling plate and the cooling module have been assembled in an at least substantially fluid tight manner, and in an at least substantially irreversible manner, and in such a way that the cooling module can distribute a flow of fluid over a surface of the cooling plate, the cooling plate and the cooling module thereby forming a monolithic unit.

In the present context the term 'power module' should be interpreted to mean a module comprising one or more electronic components mounted on one or more substrates which are in turn mounted on a cooling plate in order to provide cooling possibility for the electronic component(s). Thus, a power module comprises one or more component carriers, often called substrates, each carrying one or more power semiconductor devices, such as IGBT's, diodes, MOSFET's, GTO's, etc.

The power module according to the present invention is fluid cooled, i.e. a flow of fluid is provided for transporting heat away from the power module. The fluid may either be a liquid, such as water, or it may be a gas, such as air. Alternatively, a two-phase cooling using, e.g., R134a is possible.

The power module comprises a cooling plate with at least one substrate mounted thereon. The function of the cooling plate is to transport heat away from the substrate(s), in particular heat which has been developed by electronic components mounted on the substrate(s). Therefore the cooling plate should be made from a material having a relatively high thermal conductivity, e.g. copper or aluminium. Another property of the cooling plate is that it provides physical strength for the part of the power module holding the substrate(s), and this makes the power module more able to withstand large pressures. The cooling plate may have a substantially planar shape. However, it may alternatively have any other suitable curved shape being appropriate for the application in question.

The substrate(s) is/are preferably of the kind comprising a component carrier which carries at least one power semiconductor.

The cooling plate and the cooling module have been assembled in an at least substantially fluid tight manner. This should be understood as a manner in which the cooling fluid is prevented from leaking from the power module through the part where the cooling plate and the cooling module have been assembled, even if the cooling fluid is under pressure.

Furthermore, the cooling plate and the cooling module have been assembled in an at least substantially irreversible manner. This should be understood as a manner which prevents detaching the parts again without damaging one or both of the parts. This is opposed to a manner in which the parts may be detached and reassembled several times, e.g. when the parts are assembled by means of screws and possibly one or more gaskets.

It is an advantage that the cooling plate and the cooling module are assembled in an at least substantially irreversible manner since this considerably decreases the risk of leaking cooling fluid as compared to a reversible manner. This is particularly the case if the cooling fluid is under pressure.

Finally, the cooling plate and the cooling module are assembled in such a way that the cooling module can distribute a flow of fluid over a surface of the cooling plate. Thus, the cooling plate and the cooling module should be positioned relatively to each other in such a way that the cooling module, by means of the cooling fluid, is able to transport heat away from the cooling plate.

The cooling plate may further have a bondable frame mounted thereon in a surface area where the substrate(s) is/are mounted, thereby providing wire connections for electronic components mounted on the substrate(s). In the present context the term 'bondable frame' should be interpreted to mean a frame having connectors to which electronic components may be bonded. Thereby power and any other appropriate signals may be supplied to and from such electronic components via the connectors of the bondable frame.

In one embodiment the cooling module may comprise a housing, at least one inlet manifold in fluid connection with an exterior fluid source, at least one outlet manifold in fluid connection with an exterior fluid drain, and at least one flow cell, each establishing a fluid connection between the inlet manifold and the outlet manifold, the flow cell(s) being arranged to lead a flow of fluid from the inlet manifold to the outlet manifold while passing the flow of fluid over a surface of the cooling plate. In this embodiment cooling fluid is supplied to the inlet manifold from the exterior fluid source. The cooling fluid then passes through the flow cell(s), along the surface of the cooling plate to the outlet manifold. Finally the cooling fluid leaves the cooling module to the external fluid drain from the outlet manifold. While passing the surface via the flow cell(s) the cooling fluid carries heat away from the surface, thereby cooling the cooling plate.

The cooling module comprises a plurality of flow cells. In this case the flow cells may be arranged in parallel between the inlet manifold and the outlet manifold. Thereby it is possible to obtain a very small temperature gradient across the surface of the cooling plate. The flow cells may even be arranged in parallel along two directions of the surface of the cooling plate, thereby making it possible to obtain an even smaller temperature gradient across the surface of the cooling plate. Alternatively the plurality of flow cells may be arranged in series along one or two directions of the surface of the cooling plate.

In one embodiment at least the housing, the inlet manifold, the outlet manifold and the flow cell(s) may form a single piece. In this embodiment the cooling module is particularly easy to manufacture, thereby making the manufacturing process cost effective and well suited for mass production.

At least a part of the cooling module being responsible for distributing the flow of fluid over a surface of the cooling plate may advantageously be made from a plastic material, such as PA, PP, ABS or the like. This is an advantage because the cooling can readily be tailored to the specific application, e.g. taking specific hot spots in the power module into account, thus removing temperature gradients where needed, simply by designing the plastic part according to the temperature distribution in the power module.

According to a second aspect of the present invention the above and other objects are fulfilled by providing a method of forming a monolithic fluid cooled power module, the method comprising the steps of:
- providing a cooling plate,
- mounting at least one substrate on the cooling plate,
- providing a cooling module being adapted to distribute a flow of fluid over a surface to be cooled, and
- assembling the cooling plate and the cooling module in an at least substantially fluid tight manner, and in an at least substantially irreversible manner, and in such a way that the cooling module can distribute a flow of fluid over a surface of the cooling plate, thereby forming a monolithic unit.

It should be noted that a person skilled in the art would readily recognise that any feature described in relation to the first aspect of the invention may also be combined with the second aspect of the invention and vice versa.

The assembling step may be performed in such a way that no heating or only local heating is produced. In the present context the term 'local heating' should be interpreted as heating which is restricted to a relatively small area surrounding the point where the assembling process takes place.

In case the assembling step is performed in a way in which non-local heating is produced (i.e. in such a way that heat spreads away from a small localised area surrounding the point where the process takes place), it will be necessary to assemble the cooling plate and the cooling module before the substrate is mounted on the cooling plate because there will otherwise be a risk that the produced heat may cause damage to the substrate(s), electronic components mounted on the substrate(s), wires or soldering, etc. When the substrate is subsequently mounted on the cooling plate, the mounting process will have to take place on a much larger unit (i.e. the cooling plate as well as the cooling module). This is disadvantageous, and it is therefore desirable to be able to perform the assembling step after the substrate has been mounted on the cooling plate. Furthermore, this also makes it possible to manufacture parts of the cooling module from a material which is not very heat resistant, e.g. a plastic material, without risking damage of such parts.

The assembling step may be performed using a welding technique, such as by means of friction stir welding. Friction stir welding is a welding process in which a rotating cylindrical tool is pressed into a gap between the two parts to be joined or onto one of the parts which is placed on top of the other part. Thereby one or both of the parts melts locally, and the melted material is stirred beneath the tool, thus creating a joint between the two parts.

It is possible to weld different materials using friction stir welding, and this opens the possibility of making the cooling plate and the cooling module in two different materials. Thus, the cooling plate may be made from copper and the cooling module from aluminium. Additionally, it is possibly to join stainless steel to a number of different metals by means of stir welding. Furthermore, friction stir welding only produces very localised heat at the position of the rotating cylindrical tool, and it is therefore very suitable for the present application. However, other welding techniques may alternatively be used.

Alternatively, the assembling step may be performed by gluing the cooling plate and the cooling module together, or in any other suitable irreversible manner.

The step of providing a cooling module may comprise providing a cooling module having a housing, an inlet manifold, an outlet manifold and at least one flow cell, e.g. a plurality of flow cells, each establishing a fluid connection between the inlet manifold and the outlet manifold. The step may further comprise manufacturing at least the housing, the inlet manifold, the outlet manifold and the flow cell(s) in a single piece. As described above, this will reduce manufacturing costs and make the power module suitable for mass production.

At least a part of the cooling module being responsible for distributing the flow of fluid over a surface of the cooling plate may be manufactured from a plastic material, and in this case the step of providing a cooling module may be performed using an injection moulding technique.

The method may further comprise the steps of:
- mounting a bondable frame on the cooling plate in a surface area where the substrate(s) is/are mounted, and
- establishing wire connections between one or more electronic components mounted on the substrate and connectors attached to the bondable frame.

Thereby power and/or other appropriate signals may be supplied to and from electronic components mounted on the substrate(s).

### BRIEF DESCRIPTION OF THE DRAWINGS

The invention will now be further described with reference to the accompanying drawings in which:
Fig. 1 shows a cooling module with a housing having flow cells formed therein,
Fig. 2 shows a power module according to an embodiment of the invention with a cooling module and a cooling plate having substrates and a bondable frame attached thereto,
Fig. 3 shows the power module of Fig. 2, further being provided with a lid,
Fig. 4 is a cross section of the power module of Fig. 3 along a first line,
Fig. 5 is a cross section of the power module of Fig. 3 along a second line,
Fig. 6 shows another embodiment of a power module according to the invention with a part broken away, and
Fig. 7 is a cross section of the power module of Fig. 6.

### DETAILED DESCRIPTION OF THE DRAWINGS

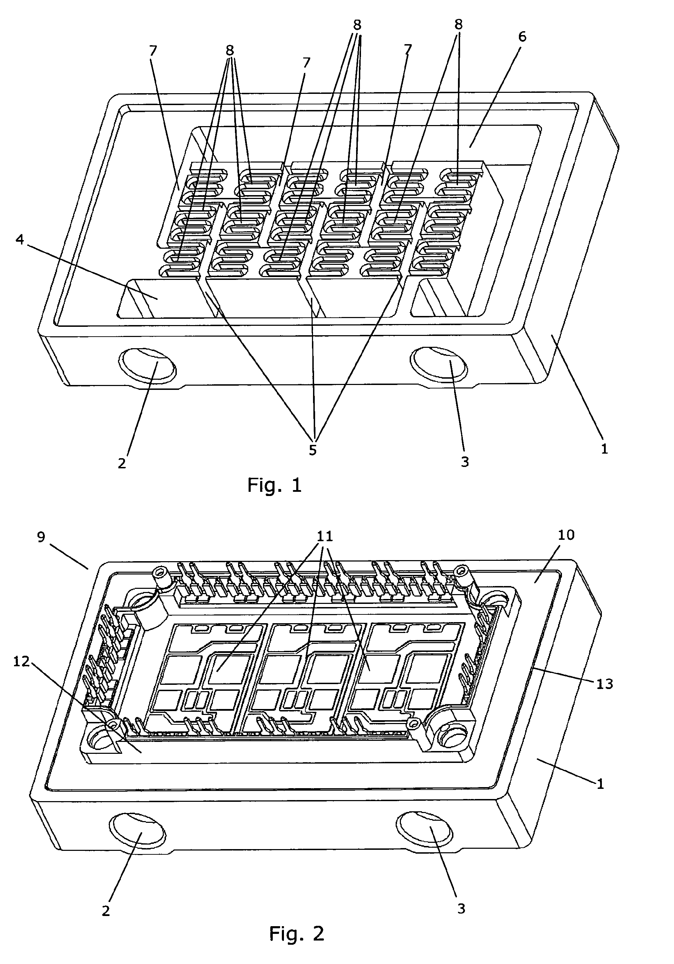

Fig. 1 is a perspective view of a cooling module 1 for use in one embodiment of a power module according to the present invention. The cooling module 1 comprises a fluid inlet 2 and a fluid outlet 3 for leading cooling fluid to and from an interior part of the cooling module 1. The fluid inlet 2 is in fluid connection with an inlet manifold 4 which is provided with three inlet manifold branches 5. Similarly, the fluid outlet 3 is in fluid connection with an outlet manifold 6 which is provided with three outlet manifold branches 7. The cooling module 1 is further provided with a plurality of flow cells 8, and each flow cell 8 establishes a fluid connection between an inlet manifold branch 5 and an outlet manifold branch 7. Thereby fluid which enters the cooling module 1 via the fluid inlet 2 will be distributed to each of the flow cells 8 via the inlet manifold 4 and the inlet manifold branches 5. The fluid then flows via the flow cells 8 along a surface to be cooled (not shown in Fig. 1) to the outlet manifold branches 7, and thereby to the outlet manifold 7 and further on to the fluid outlet 3 where it leaves the cooling module 1.

The flow cells 8 are arranged in a two-dimensional pattern. Since the fluid entering each flow cell 8 will have substantially the same temperature, this will provide a cooling of a surface (not shown) which is very uniform, i.e. with only very small temperature gradients across the surface. This arrangement of the flow cells 8 is possible due to the positions and shapes of the inlet manifold branches 5 and the outlet manifold branches 7.

Fig. 2 is a perspective view of a power module 9 according to an embodiment of the invention. The power module 9 comprises a cooling module 1 like the one shown in Fig. 1. The power module 9 further comprises a cooling plate 10 having three substrates 11 and a bondable frame 12 mounted thereon. The cooling plate 10 is positioned adjacent the flow cells (not visible) of the cooling module 1, and fluid flowing through the flow cells can thereby be used for cooling the cooling plate 10, in particular electronic components mounted on the substrates 11 of the cooling plate 10.

The cooling module 1 and the cooling plate 10 have been assembled in a fluid tight an irreversible manner. This may be done by gluing or welding the cooling module 1 and the cooling plate 10 together along seam 13. Preferably, the cooling module 1 and the cooling plate 10 have been welded together by means of friction stir welding.

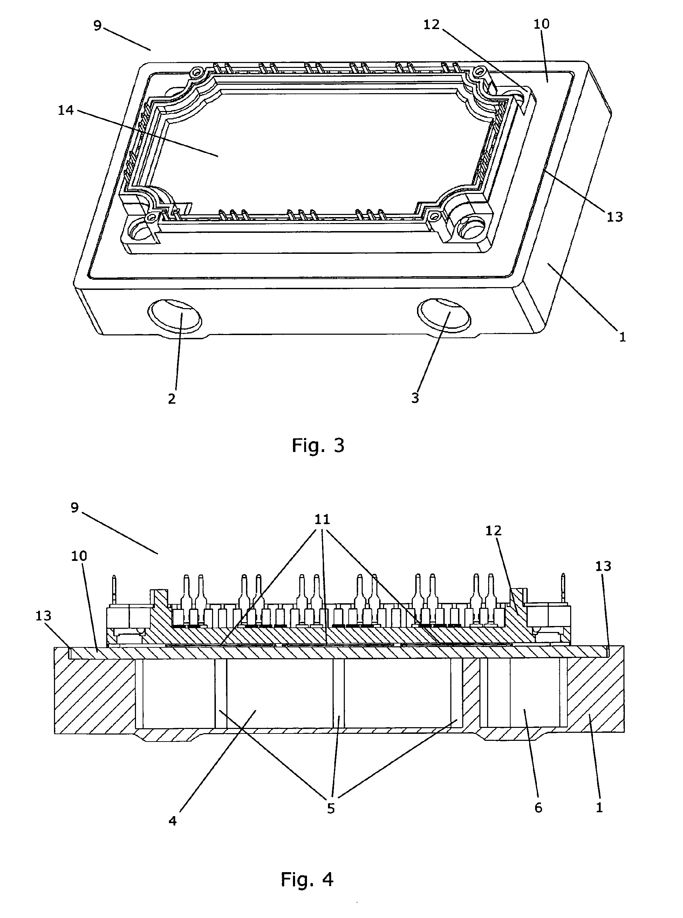

Fig. 3 is a perspective view of the power module 9 of Fig. 2, but further being provided with a lid 14 which is attached to the bondable frame 12 and covers the substrates (not visible). Prior to attaching the lid 14 to the bondable frame 12 the cavity defined by the substrates, the side walls of the bondable frame 12 and the lid 14 is preferably filled with a silicon gel in order to protect the semiconductor devices against humidity, in order to provide electrical insulation between parts featuring different electrical potentials (e.g. in the order of several kV), and in order to provide mechanical protection, e.g. against vibrations.

Fig. 4 is a cross section of the power module 9 of Fig. 3 along a line extending along a longitudinal direction of the power module 9 and through the inlet manifold 4. In Fig. 4 inlet openings of the three inlet manifold branches 5 are visible, and it can be seen that the inlet manifold branches 5 are fluidly connected to the inlet manifold 4. Furthermore, the substrates 11, the bondable frame 12 and the seam 13 can be seen.

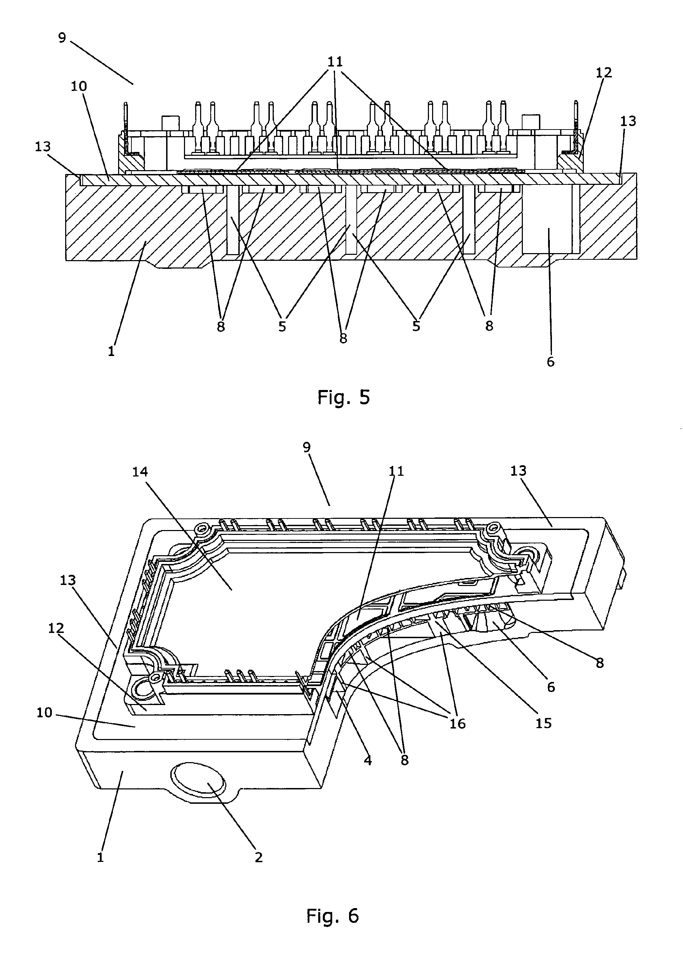

Fig. 5 is a cross section of the power module 9 of Fig. 3 along a line which is parallel to the line of Fig. 4, but which extends through a part containing flow cells 8. In Fig. 5 the flow cells 8 are therefore visible as well as the inlet manifold branches 5. Furthermore, as in Fig. 4, the substrates 11, the bondable frame 12 and the seam 13 can be seen.

Fig. 6 is a perspective view of a power module 9 according to another embodiment of the invention with a part broken away. Similarly to the embodiment shown in Figs. 1-5, the power module 9 shown in Fig. 6 comprises a cooling module 1, a cooling plate 10 with substrates 11 and a bondable frame 12 mounted thereon. Furthermore, a lid 14 is attached to the bondable frame 12. The cooling plate 10 and the cooling module 1 have been assembled in a fluid tight and irreversible manner along seam 13 as described above.

Inside the cooling module 1 is positioned a baffle 15. The baffle is shaped in such a way that a lower side of the baffle 15 carries an inlet manifold 4 and an outlet manifold 6. The inlet manifold 4 and the outlet manifold 6 are defined by wall segments 16. An upper side of the baffle 15 carries a plurality of flow cells 8. Each of the flow cells 8 is fluidly connected to the inlet manifold 4 via an inlet opening (not shown) and fluidly connected to the outlet manifold 6 via an outlet opening (not shown). Thereby each flow cell 8 establishes a fluid connection between the inlet manifold 4 and the outlet manifold 6. The outline of the flow cells 8 is preferably very similar to the outline of the flow cells 8 shown in Fig. 1.

According to this embodiment the baffle 15 is a separate member which is simply positioned in a cavity of the cooling module 1 before the cooling plate 10 and the cooling module 1 are assembled. The baffle 15 may preferably be made from a different material than the cooling module 1 and the cooling plate 10. In case the cooling module 1 and the cooling plate 10 are welded together, e.g. by means of friction stir welding, these parts need to be made from metal, e.g. the cooling module 1 being made from aluminium and the cooling plate 10 being made from copper. In this case the baffle 15 may advantageously be made from a plastic material, or from another mouldable material, thereby making manufacturing of the power module 9 very simple.

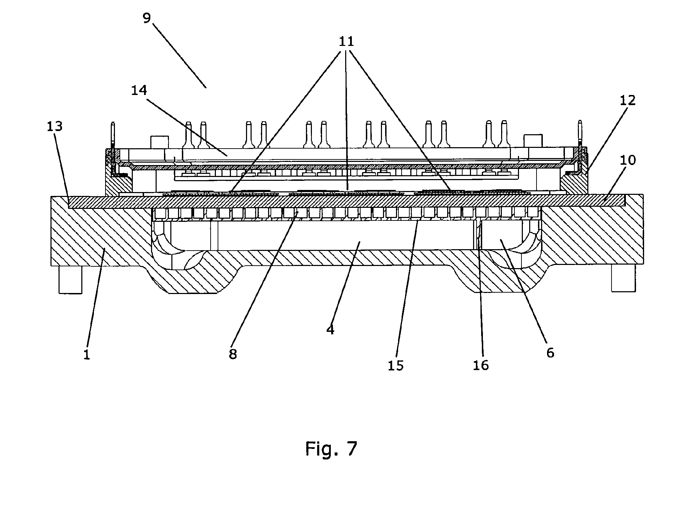

Fig. 7 is a cross section of the power module 9 of Fig. 6 along a longitudinal direction. The input manifold 4, the output manifold 6 and the flow cells 8 are visible, as well as the substrates 11 mounted on the cooling plate 10.

## Claims

1. A monolithic fluid cooled power module comprising a cooling plate with at least one substrate mounted thereon and a cooling module adapted to distribute a flow of fluid over a surface to be cooled, wherein the cooling plate and the cooling module have been assembled in an at least substantially fluid tight manner, and in an at least substantially irreversible manner, and in such a way that the cooling module can distribute a flow of fluid over a surface of the cooling plate, the cooling plate and the cooling module thereby forming a monolithic unit.

2. A monolithic fluid cooled power module according to claim 1, wherein the cooling plate further has a bondable frame mounted thereon in a surface area where the substrate(s) is/are mounted, thereby providing wire connections for electronic components mounted on the substrate(s).

3. A monolithic fluid cooled power module according to claim 1 or 2, wherein the cooling module comprises a housing, at least one inlet manifold in fluid connection with an exterior fluid source, at least one outlet manifold in fluid connection with an exterior fluid drain, and at least one flow cell, each establishing a fluid connection between the inlet manifold and the outlet manifold, the flow cell(s) being arranged to lead a flow of fluid from the inlet manifold to the outlet manifold while passing the flow of fluid over a surface of the cooling plate.

4. A monolithic fluid cooled power module according to claim 3, wherein the cooling module comprises a plurality of flow cells.

5. A monolithic fluid cooled power module according to claim 4, wherein the flow cells are arranged in parallel between the inlet manifold and the outlet manifold.

6. A monolithic fluid cooled power module according to claim 5, wherein the flow cells are arranged in parallel along two directions of the surface of the cooling plate.

7. A monolithic fluid cooled power module according to any of claims 3-6, wherein at least the housing, the inlet manifold, the outlet manifold and the flow cell(s) form a single piece.

8. A monolithic fluid cooled power module according to any of the preceding claims, wherein the cooling plate and the cooling module have been assembled using a welding technique.

9. A monolithic fluid cooled power module according to claim 8, wherein the cooling plate and the cooling module have been assembled by means of friction stir welding.

10. A monolithic fluid cooled power module according to any of the preceding claims, wherein at least a part of the cooling module being responsible for distributing the flow of fluid over a surface of the cooling plate is made from a plastic material.

11. A method of forming a monolithic fluid cooled power module, the method comprising the steps of:
- providing a cooling plate,
- mounting at least one substrate on the cooling plate,
- providing a cooling module being adapted to distribute a flow of fluid over a surface to be cooled, and
- assembling the cooling plate and the cooling module in an at least substantially fluid tight manner, and in an at least substantially irreversible manner, and in such a way that the cooling module can distribute a flow of fluid over a surface of the cooling plate, thereby forming a monolithic unit.

12. A method according to claim 11, wherein the assembling step is performed in such a way that no heating or only local heating is produced.

13. A method according to claim 11 or 12, wherein the assembling step is performed using a welding technique.

14. A method according to claim 13, wherein the assembling step is performed by means of friction stir welding.

15. A method according to any of claims 11-14, wherein the step of providing a cooling module comprises providing a cooling module having a housing, an inlet manifold, an outlet manifold and at least one flow cell, each establishing a fluid connection between the inlet manifold and the outlet manifold.

16. A method according to claim 15, wherein the step of providing a cooling module comprises providing a cooling module having a plurality of flow cells.

17. A method according to claim 15 or 16, wherein the step of providing a cooling module comprises manufacturing at least the housing, the inlet manifold, the outlet manifold and the flow cell(s) in a single piece.

18. A method according to any of the preceding claims, wherein the step of providing a cooling module comprises making at least a part of the cooling module being responsible for distributing the flow of fluid over a surface of the cooling plate from a plastic material

19. A method according to claim 18, wherein the step of providing a cooling module is performed using an injection moulding technique.

20. A method according to any of claims 11-19, further comprising the steps of:
- mounting a bondable frame on the cooling plate in a surface area where the substrate(s) is/are mounted, and
- establishing wire connections between one or more electronic components mounted on the substrate and connectors attached to the bondable frame.
